# EUROPEAN PATENT SPECIFICATION

(11) **EP 3 634 095 B1**
(45) Date of publication and mention of the grant of the patent: **16.03.2022**
(21) Application number: 18198223.2
(22) Date of filing: 02.10.2018
(51) Int. Cl.: H05K 7/20, H01L 23/40, H01L 25/11

(54) **POWER INVERTER**
WECHSELRICHTER
ONDULEUR DE PUISSANCE

(43) Date of publication of application: 08.04.2020
(73) Proprietor: Mahle International GmbH, 70376 Stuttgart (DE)
(72) Inventor: BOZIC, Jernej, 5250 Solkan (SI); BUCIK, Silvan, 5250 Solkan (SI); STOLFA, Danijel, 5250 Solkan (SI)
(74) Representative: BRP Renaud & Partner mbB Rechtsanwälte Patentanwälte Steuerberater

(56) References cited:
- EP-A1- 1 184 905
- WO-A1-2017/157527
- US-B2- 7 845 994

## Description

The invention relates to a power inverter for an electrical machine, according to the preamble of Claim 1. The invention further relates to an electrical machine having said power inverter.

In a generic power inverter, a direct current is converted into a three-phase alternating current. The power inverter can be employed for the propulsion of an electrical machine for example in a motor vehicle, wherein the direct current is tapped from a battery, is converted into an alternating current, and is fed to the electrical machine. The electrical machine can be a permanently excited or separately excited synchronous machine, an asynchronous machine or another type of electrical machine.

For the conversion of a direct current into an alternating current, the power inverter customarily incorporates a power circuit board having a plurality of capacitors and a plurality of power semiconductors, which are electrically interconnected. In operation, the power inverter generates a large quantity of heat energy, and the power semiconductors in particular require intensive cooling. To this end, the power circuit board is connected to a heat-conducting cooling plate in a thermally conductive manner, and the heat generated in the power semiconductors is evacuated via the power circuit board and a layer of insulating foil to the cooling plate. US 7 845 994 B2 discloses an electric motor with a printed circuit board having a plurality of power semiconductors. The power semiconductors are arranged perpendicularly to the printed circuit board and are pressed to a housing wall via a pre-loaded spring element in a heat-transferring manner. Thus, the power semiconductors can be cooled via the housing wall.

The object of the invention is the disclosure of an alternative form of embodiment of a power inverter of the generic type, in which the cooling of the power inverter is improved. A further object of the invention is the provision of an electrical machine having a power inverter which is effectively cooled.

According to the invention, these objects are fulfilled by the subject matter of the independent claims. Advantageous forms of embodiment are the subject matter of the dependent claims.

The present invention is based upon the general concept, whereby the power semiconductors in a power inverter for an electrical machine which are to be cooled are directly or immediately coupled to a heat sink. The power inverter thus comprises a power circuit board with a plurality of power semiconductors. Furthermore, the power inverter comprises a housing with a housing wall, which extends around a central longitudinal axis of the housing. The power circuit board is fitted here in the housing perpendicularly to the central longitudinal axis. According to the invention, the power semiconductors are arranged in an edge region of the power circuit board, and are oriented perpendicularly to the latter and axially to the central longitudinal axis. The power inverter also incorporates a preloading arrangement having at least one resilient clamp and a clamping plate in parallel with the power circuit board. The at least one resilient clamp is pre-loaded between at least one of the power semiconductors and the clamping plate, and compresses at least one of the power semiconductors against an inner surface of the housing wall.

In the power inverter according to the invention, at least one of the power semiconductors is compressed against the inner surface of the housing wall, and is thus in direct and immediate contact with the latter. It is understood that a heattransmitting and perhaps insulating layer can be arranged between the power semiconductors and the housing wall. The housing wall forms a heat sink here for the respective power semiconductor and the heat generated in the respective power semiconductor can be directly and immediately evacuated into the housing wall, and from thence further outwards. Specifically, the cooling of the respective power semiconductor in the power converter according to the invention can be improved as a result, as no additional layers or only a heat-conducting and perhaps insulating layer for the restriction of thermal conduction are arranged between the respective power semiconductor and the heat sink. The preloading arrangement compresses the respective power semiconductor against the housing wall, such that the power semiconductor is also protected against undesirable vibrations. The housing wall or the housing can thus be formed of a thermally conductive material - for example, of a metal such as aluminium - such that thermal conduction between the respective power semiconductor and the housing wall, and between the housing wall and the surrounding environment, is improved.

Advantageously, between the inner surface of the housing wall and at least one of the power semiconductors, a heat-conducting layer can be secured in contact with the latter. The heat-conducting layer thus lies in direct contact, on one side, with the respective power semiconductor and, on the other side, with the inner surface of the housing wall, and can thus improve thermal conduction between the respective power semiconductor and the housing wall. The heat-conducting layer is preferably a heat-conducting film or a heat-conducting paste, or a casting compound of a heat-conducting material. The heat-conducting layer can further insulate the power semiconductors from the housing wall.

In the preloading arrangement according to the invention, it is provided that at least one carrier of the preloading arrangement is secured to the housing wall and is oriented here perpendicularly to the central longitudinal axis and is oriented in parallel with at least one of the power semiconductors. The at least one resilient clamp then comprises two flat prongs, which are connected to each other by a bearing section. The carrier may be a carrier shaft here, on which the respective resilient clamp is rotatably mounted by means of the bearing section. The carrier is oriented in parallel with at least one of the power semiconductors, and secures the respective resilient clamp between at least one of the power semiconductors and the clamping plate. Appropriately, the one prong is pressed against at least one of the power semiconductors, and the other prong is pressed against the clamping plate, such that the power semiconductor is compressible against the inner surface of the housing wall, and can thus be directly coupled to the housing wall in a thermally conductive manner. In order to vary a compression force of the respective resilient clamp on at least one of the power semiconductors, the one prong may be of a different length to the other prong.

In order to simplify the execution of the clamping plate, according to the invention, the clamping plate incorporates a clamping edge which is oriented in parallel with the respective carrier. In this case, one prong of the at least one resilient clamp engages with at least one of the power semiconductors, and the other prong of the at least one resilient clamp engages with the clamping edge of the clamping plate, in a pre-loaded arrangement. Alternatively or additionally, the clamping plate can incorporate at least one stop lug, which engages with the bearing section of the at least one resilient clamp, parallel to the respective carrier. The at least one resilient clamp can thus be attached to the carrier in a non-displaceable manner, and the respective power semiconductor is securely coupled to the housing wall in a thermally conductive manner. The stop lug can, moreover, secure the at least one carrier axially to the power semiconductors. The clamping plate can, moreover, incorporate a fixing edge, which secures the bearing section of the at least one resilient clamp to the respective carrier, axially to the central longitudinal axis and to the power circuit board. The fixing edge prevents any unwanted detachment of the at least one resilient clamp from the carrier and secures the thermally conductive contact between the respective power semiconductor and the housing wall.

In order to constitute a large-surface thermally conductive coupling between the power semiconductors and the housing wall, it can advantageously be provided that, on the inner surface of the housing wall, at least one planar clamping section is configured for at least one of the power semiconductors. The planar power semiconductor can then assume a large-surface thermally conductive contact with the planar clamping section configured on the inner surface of the housing wall, thereby improving heat conduction between the respective power semiconductor and the housing wall. Moreover, a plurality of planar clamping sections can be configured in the circumferential direction, distributed over the inner surface of the housing wall. However, three clamping sections are preferably formed in the housing wall. Accordingly, a plurality of power semiconductors can assume a large-surface contact with the inner surface of the housing wall, and can be configured in a space-saving arrangement.

In a further development of the preloading arrangement, it is advantageously provided that, for each of the clamping sections, a respective carrier and, for each of the power semiconductors in the respective clamping section, a respective resilient clamp are provided on the carrier. In the respective clamping section, the individual power semiconductors are compressed against the inner surface by the individual resilient clamps. The individual resilient clamps are supported by the bearing sections on the respective carrier, and are arranged between the individual power semiconductors and the clamping plate by means of the carrier. The individual resilient clamps or, alternatively, an entire row of the individual resilient clamps can be secured on the carrier in a non-displaceable manner by means of the stop lugs on either side of the clamping plate. By means of the fixing edge moreover, the individual resilient clamps can also be secured axially to the central longitudinal axis and to the power board. The prongs of the individual resilient clamps are thus pre-loaded between the clamping edge of the clamping plate and the individual power semiconductors, such that the individual power semiconductors are compressed against the inner surface of the housing wall in the respective clamping section. One of the resilient clamps on the carrier is assigned to each of the power semiconductors, such that the individual power semiconductors are compressed against the inner surface of the housing wall with an equal compression force. As a result, advantageously, uniform heat conduction between the individual power semiconductors and the housing wall and a uniform cooling of the individual power semiconductors can be achieved.

In an advantageous development of the power inverter according to the invention, it is provided that a plurality of capacitors are orientated perpendicularly to the power circuit board, and towards the clamping plate, on the power circuit board. The clamping plate incorporates at least one through opening here, into which the capacitors project axially with respect to the central longitudinal axis. Additionally, on the clamping plate, a capacitor retaining plate, which is averted from the power circuit board, can be fitted or can be integrally configured. The capacitor retaining plate thus positions the capacitors which project axially through the respective through opening in the clamping plate, radially to the central longitudinal axis. To this end, the capacitor retaining plate preferably incorporates location openings, in which the capacitors are radially located. As the capacitors are customarily soldered to the power circuit board, the capacitor retaining plate can prevent any interruption of the rigid and brittle soldered contacts on the power circuit board associated with vibrations or oscillations.

Advantageously, it can be provided that a control board is fitted, averted from the clamping plate, between the power circuit board and a housing base perpendicularly to the central longitudinal axis. The control board is at a distance and electrically insulated from the housing base and the power circuit board. To this end, for example, spacing screws can be provided, which are fitted on one side to the housing base and on the other side to the control board, and maintain a clearance between the latter and the housing base. The control board can, moreover, incorporate an electric power connector, which is averted from the power circuit board and is brought out to the exterior through a terminal opening in the housing base. By means of the electric power connector, the control board and, correspondingly, the power inverter can be connected to an external DC voltage source and/or to an external control circuit in a signal-transmitting arrangement.

The control board can, moreover, incorporate a positive pole contact terminal and a negative pole contact terminal which, by means of a respective conductor, electrically bond the control board to the power circuit board, preferably in the form of current-conducting studs which are routed through the power circuit board, axially to the central longitudinal axis. The positive pole contact terminal and negative pole contact terminal can appropriately be connected to the electric power connector in an electrically conductive manner, in order to conduct direct current from an external direct current source via the respective current-conducting studs to the power circuit board. The respective current-conducting studs can, moreover, fit the control board with a clearance to the housing base and to the power circuit board, for which purpose the respective current conducting studs can incorporate at least one radial stop rim or a radially oriented stop moulding. The respective current-conducting studs are appropriately fitted to the housing base in an electrically insulated arrangement.

On the power circuit board, the power semiconductors can constitute a power circuit having three phase terminals, wherein the phase terminals are arranged on the power circuit board perpendicularly to the central longitudinal axis, facing a housing opening in the housing wall, and are accessible from the exterior. Advantageously, a respective phase terminal can be electrically bonded with a respective half-bridge circuit, in which two of the power semiconductors, or a whole-number multiple thereof, are electrically interconnected. The phase terminals can then extend from the respective half-bridge circuits to a contact zone, which is arranged on the closable housing opening of the housing. Via the electric power connector, the power inverter can be supplied with direct current from an external direct current source, which can be routed from the positive pole contact terminal and the negative pole contact terminal via the respective conductors or the current-conducting studs to the power circuit board. A three-phase alternating current can be tapped off from the power inverter via the phase terminals. The phase terminals are accessible from the exterior through the housing opening, such that phase terminal pins of an electrical machine can be secured to phase terminals, for example by soldering. In order to protect the power circuit board and the control board against fouling, the power inverter can be provided with a cover for the closure of the housing opening. The cover can, moreover, be sealed from the exterior by means of an annular seal, such that the power circuit board and the control board are also protected against moisture.

In order to improve the cooling of the power semiconductors, a plurality of cooling ribs can be integrally moulded on an outer surface of the housing wall, which is averted from the inner surface. Alternatively or additionally, a plurality of cooling ribs can also be moulded on an outer surface of a housing base, which is averted from the power circuit board. The cooling ribs enlarge the external surface of the housing wall and the housing base, such that heat conduction between the housing wall, the housing base and the environment is improved. As a result, heat generated in the power semiconductors can also be evacuated more effectively. Alternatively or additionally to the cooling ribs, a cooling device can be coupled to the outer surface of the housing wall which is averted from the inner surface and/or to the outer surface of a housing base which is averted from the power circuit board, in a thermally conductive manner. The housing wall and the housing base can then be cooled by means of a cooling medium which is carried in the cooling device, and the heat generated in the power semiconductors can be effectively evacuated.

Advantageously, an electrical machine can be fitted to the power inverter, wherein a drive shaft axis of a drive shaft of the electrical machine is oriented in parallel with the central longitudinal axis. The electrical machine and the power inverter can, moreover, be arranged coaxially to each other. The electrical machine can, for example, be a permanently excited or separately excited synchronous machine, an asynchronous machine or another type of electrical machine. A machine wall closes the housing perpendicularly to the central longitudinal axis, and clamps the clamping plate in the housing axially to the central longitudinal axis, in a pre-loaded arrangement. In this manner, the machine wall constitutes a housing cover of the power inverter, which is appropriately arranged in opposition to the housing base. The machine wall thus clamps the clamping plate in a preloading arrangement, such that the power semiconductors are compressed against the inner surface of the housing wall. As a result, specifically, additional means for the axial fixing of the clamping plate in the housing of the power inverter are omitted, and the power inverter is of a simplified and comparatively cost-effective design. Preferably, the electrical machine is fitted to the power inverter at an opposite end thereof to the drive shaft, in order to prevent any disturbance to the operation of the electrical machine. The phase terminal pins of the electrical machine are appropriately axially insertable into the power inverter, up to the phase terminals on the power circuit board, and can be electrically bonded with the latter - for example by soldering - via the housing opening in the housing wall.

In summary, the power semiconductors in the power inverter according to the invention are directly and immediately coupled to the inner surface of the housing wall in a thermally conductive manner, said inner surface forming a heat sink here. Between the inner surface of the housing wall and the respective power semiconductors, no layers or only a heat-conducting and perhaps insulating layer are arranged, such that heat conduction between the respective power semiconductors and the housing wall, and thus the cooling of the respective power semiconductors, is improved.

The invention further relates to an electrical machine having a drive shaft which is rotatable about a drive shaft axis and having a power inverter. According to the invention, the power inverter can be configured as described above. The electrical machine can, for example, be a permanently excited or separately excited synchronous machine, an asynchronous machine or another type of electrical machine. Preferably, the power inverter is configured coaxially to the electrical machine. A machine wall constitutes a housing cover of the power inverter, and closes the housing of the power inverter perpendicularly to the central longitudinal axis of the power inverter. The electrical machine is appropriately fitted to the power inverter at an opposite end thereof to the drive shaft, in order to prevent any disturbance to the operation of the electrical machine.

Further significant characteristics and advantages of the invention proceed from the sub-claims, from the drawings, and from the associated description of the figures, which refers to the drawings.

It is understood that the above-mentioned characteristics, and those described hereinafter, can be employed not only in the respective combination indicated, but also in other combinations, or in isolation, without departing from the scope of the present invention, as defined in the appended claims.

Preferred exemplary embodiments of the invention are represented in the drawings and are described in greater detail in the following description, wherein identical reference symbols refer to identical, similar or functionally equivalent components.

In the drawings, schematically in each case:
- Fig. 1: shows an exploded view of a power inverter according to the invention;
- Fig. 2: shows a view of the assembled power inverter, as represented in Fig. 1;
- Figs 3 and 4: show views of a control board in the power inverter represented in Fig. 1 and Fig. 2;
- Fig. 5: shows a view of a power circuit board in the power inverter represented in Fig. 1 and Fig. 2;
- Fig. 6: shows a view of a plurality of carriers and resilient clamps in a preloading arrangement of the power inverter represented in Fig. 1 and Fig. 2;
- Figs 7 and 8: show views of a clamping plate in a preloading arrangement of the power inverter represented in Fig. 1 and Fig. 2;
- Fig. 9: shows a view of a capacitor retaining plate in the power inverter represented in Fig. 1 and Fig. 2;
- Fig. 10: shows an exploded view of the power inverter represented in Fig. 1 and Fig. 2, with an electrical machine;
- Figs 11 and 12: show views of an electrical machine according to the invention, with the power inverter represented in Fig. 1 and Fig. 2.

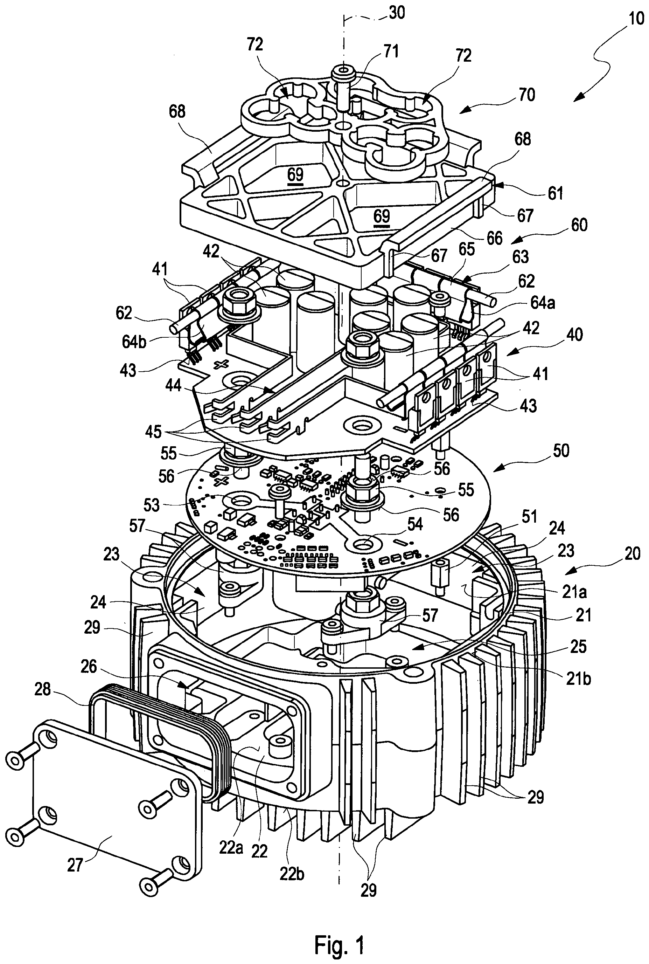

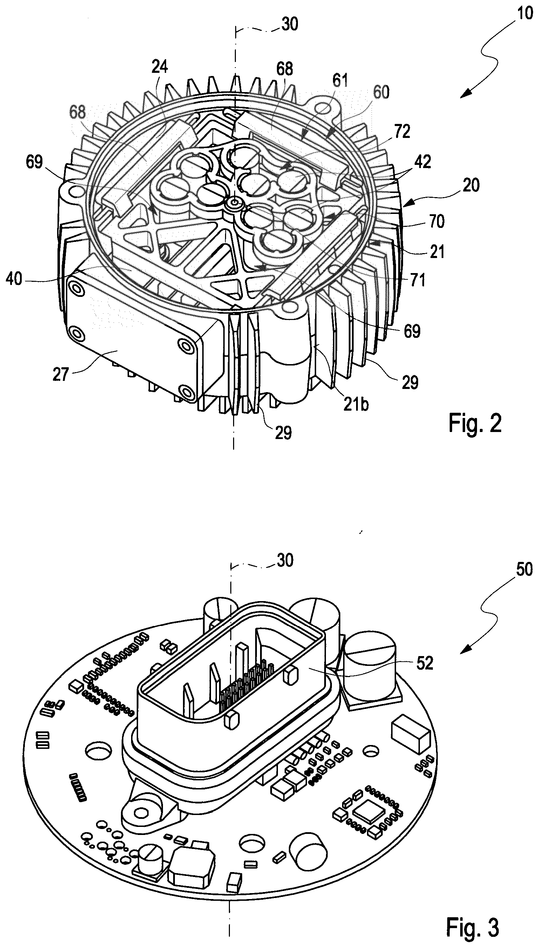

Fig. 1 shows an exploded view, and Fig. 2 shows a view of a power inverter 10 according to the invention. The power inverter 10 incorporates a housing 20 with a housing wall 21 which extends around a central longitudinal axis 30 of the housing 20. The housing 20 further incorporates a housing base 22 which, on one side, closes the housing 20 perpendicularly to the central longitudinal axis 30. In the housing 20, a power circuit board 40 having a plurality of power semiconductors 41 and a plurality of capacitors 42 is fitted perpendicularly to the central longitudinal axis 30. Between the housing base 22 and the power circuit board 40, a control board 50 is fitted perpendicularly to the central longitudinal axis 30. The control board 50 is arranged with a clearance to the housing base 20 and to the power circuit board 40, and is electrically insulated from the latter. On the power circuit board 40, a preloading arrangement 60 is further arranged, averted from the control board 50, which incorporates a clamping plate 61, carrier 62 and resilient clamps 63. A capacitor retaining plate 70 is arranged on the clamping plate 61, averted from the power circuit board 40.

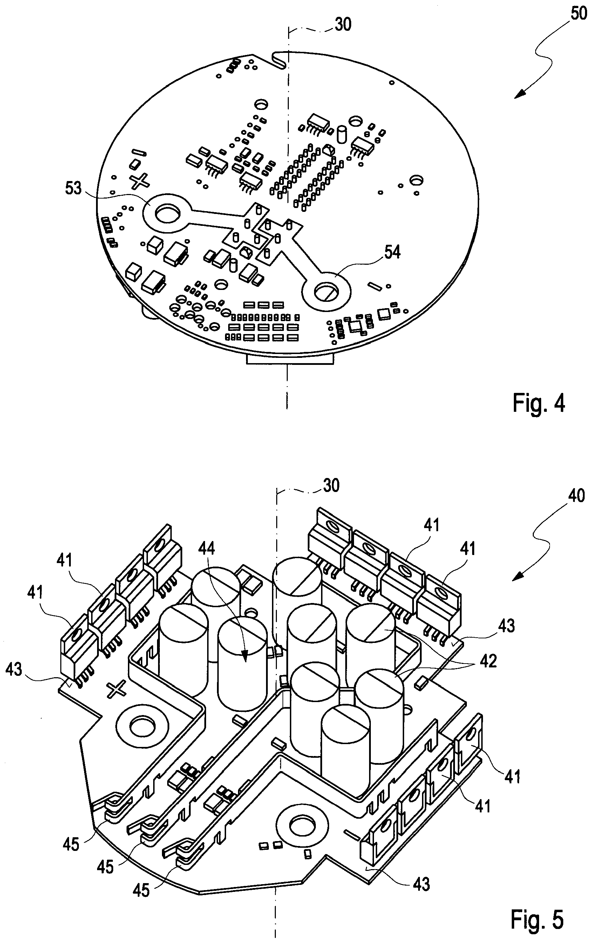

The power semiconductors 41, in an edge region 43 of the power circuit board 40, are oriented perpendicularly to the latter and in parallel with the central longitudinal axis 30, as also represented in Fig. 5. The resilient clamps 63 of the preloading arrangement 60 are pre-loaded between the power semiconductors 41 and the clamping plate 61, and compress the power semiconductors 41 against an inner surface 21a of the housing wall 21. As a result, the power semiconductors 41 are directly and immediately bonded with the housing wall 21, and the heat generated in the power semiconductors 41 can be directly evacuated to the housing wall 21, and from thence further outwards. As no additional layers or only a heat-conducting and perhaps insulating layer are arranged between the respective power semiconductors 41 and the housing wall 21, the cooling of the power semiconductors 41 in the power inverter 10 according to the invention is significantly improved.

The power semiconductors 41 are arranged with large-surface contact to the inner surface 21a of the housing wall 21, for which purpose the housing wall 21 incorporates planar clamping sections 23. In this exemplary embodiment, a total of three clamping sections 23, distributed in the circumferential direction, are formed in the housing wall 21, in each of which four power semiconductors 41 are coupled to the housing wall 21 in a thermally conductive manner. In order to further improve heat conduction between the power semiconductors 41 and the housing wall 21, a heat-conducting layer 24 - in this case, a heat-conducting film - is respectively arranged in contact with the inner surface 21a in the respective clamping sections 23. The heat-conducting layer 24 thus forms a direct contact, on one side with the power semiconductors 41 and on the other side with the inner surface 21a of the housing wall 21, in the respective clamping section 23.

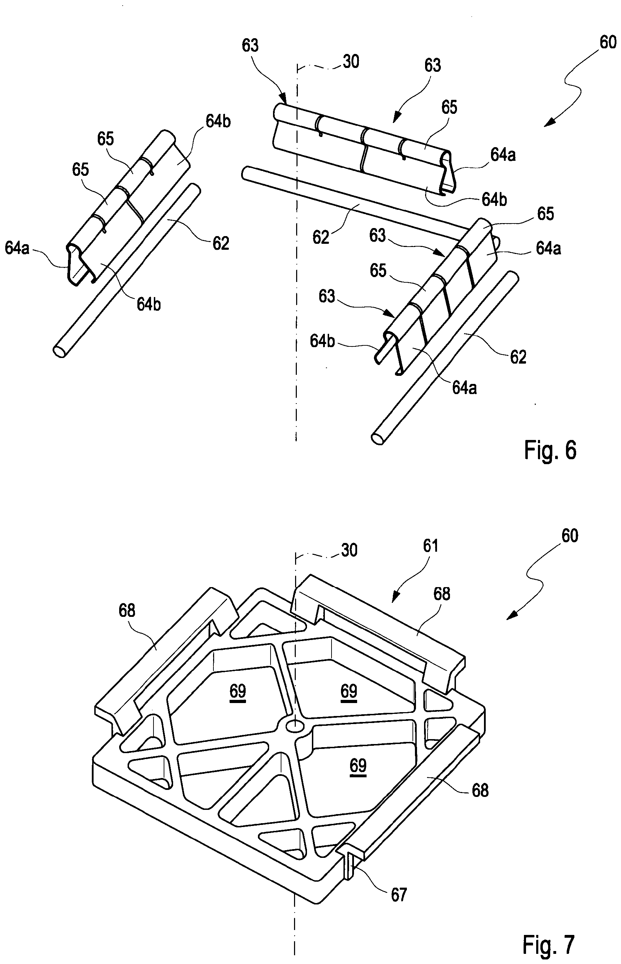

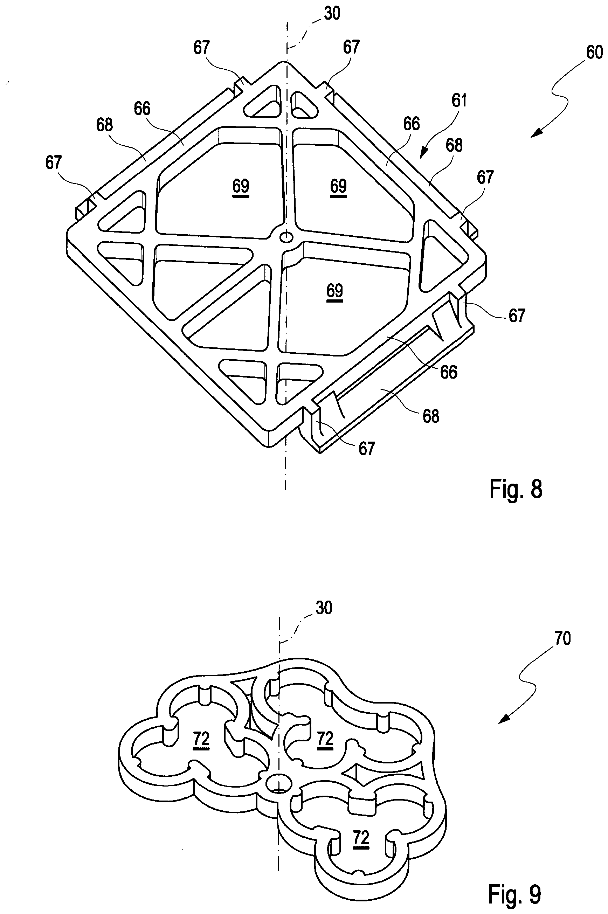

The carriers 62 of the preloading arrangement 60 are fitted to the housing wall 21, and are oriented perpendicularly to the central longitudinal axis 30 and in parallel with the power semiconductors 41 in the respective clamping sections 23. As also shown in Fig. 6, each resilient clamp 63 comprises two flat prongs 64a and 64b, which are connected to each other by a bearing section 65 which is arranged on the respective carrier 62. The prongs 64a and 64b can be of mutually differing lengths, in order to vary a compression force applied by the respective resilient clamps 63 to the power semiconductors 41. The respective carrier 62 is a carrier shaft here, on which the respective resilient clamps 63, at their bearing section 65, are rotatably mounted. The clamping plate 62 incorporates a clamping edge 66, which is oriented in parallel with the respective carrier 62, for the pre-loading of the respective resilient clamps 63, as also represented in Fig. 7 and Fig. 8. One prong 64a engages with the adjoining power semiconductors 41, and the other separate prong 64b of the respective resilient clamp 63 applies force to the clamping edge 66 of the clamping plate 61. The clamping plate 61 further incorporates stop lugs 67, which engage with the bearing sections 65 of the resilient clamps 63, in parallel with the respective carrier 62. In this manner, the resilient clamps 63 arranged on the respective carrier 62 are secured to the respective carrier 62 on both sides, in a non-displaceable arrangement. A fixing edge 68 of the clamping plate 61 additionally secures the bearing sections 65 of the resilient clamps 63, axially to the central longitudinal axis 30. By means of the preloading arrangement 60, the power semiconductors 41 assume a large-surface contact with the inner surface 21a of the housing wall 21, in the respective clamping sections 23, and heat conduction between the power semiconductors 41 and the housing wall 21 is improved.

The plurality of capacitors 42 on the power circuit board 40 are oriented perpendicularly to the power circuit board 40 and to the clamping plate 61, and project into through openings 69 in the clamping plate 61. The capacitor retaining plate 70 is secured to the clamping plate 61 by means of a screw 71, and incorporates a plurality of location openings 72, as also represented in Fig. 9. The capacitor retaining plate 70 positions the capacitors 42, which project axially through the respective through openings 69 in the clamping plate 61, in the location openings 72 radially to the central longitudinal axis 30, and prevents any interruption of the customarily rigid and brittle soldered contacts between the capacitors 42 and the power circuit board 40 associated with vibrations or oscillations.

The control board 50 is secured perpendicularly to the central longitudinal axis 30, between the power circuit board 40 and the housing base 22, with a clearance to the latter, by means of spacing screws 51. As also shown in Fig. 3, the control board 50 incorporates an electric power connector 52. The electric power connector 52, averted from the power circuit board 40, is brought out to the exterior via a terminal opening 25 in the housing base 22. By means of the electric power connector 52, the control board 50 and, correspondingly, the power inverter 10 can be connected to an external direct current source and/or to an external control circuit in a signal-transmitting arrangement. The control board 50 further incorporates a positive pole contact terminal 53 and a negative pole contact terminal contact 54, as also shown in Fig. 6. The positive pole contact terminal 53 and the negative pole contact terminal 54 are electrically bonded to the power circuit board 40 by means of a respective current-conducting stud 55. The current-conducting studs 55 are routed through the power circuit board 40, axially to the central longitudinal axis 30, and each incorporate two stop rims 56, which extend radially and are formed on the respective current-conducting stud 55, with an axial clearance in relation to each other. The control board 50 and the power circuit board 40 thus engage with the stop rims 56 of the respective current-conducting stud 55 and, in this manner, additionally to the spacing screws 51, are secured with an axial clearance in relation to each other. The current-conducting studs 55 are fitted to an inner surface 22a of the housing base 22, by means of electrically insulating bracing elements 57.

Appropriately, the positive pole contact terminal 53 and the negative pole contact terminal 54 are connected to the electric power connector 52 in a current-conducting manner, such that direct current can be fed from an external direct current source to the power circuit board 40. The direct current delivered to the power circuit board 40 is fed to a power circuit 44, and an alternating current can be tapped off from three phase terminals 45 - cf. Fig. 5. The respective phase terminal 45 is electrically bonded to one half-bridge circuit respectively, in which power semiconductors 41 are electrically interconnected. In this exemplary embodiment, four power semiconductors 41 arranged in the respective clamping section 23 respectively constitute a half-bridge circuit. The phase terminals 45 are arranged on the power circuit board 40, perpendicularly to the central longitudinal axis 30 and opposite a housing opening 26 in the housing wall 21, such that the phase terminals 45 are also accessible from the exterior. In order to protect the power circuit board 40 and the control board 50 against fouling, the power inverter 10 incorporates a cover 27 for the closure of the housing opening 26. Moreover, the cover 27 is sealed from the exterior by means of an annular seal 28, such that the power circuit board 40 and the control board 50 are additionally protected against moisture.

In order to improve the cooling of the power inverter 10, and specifically of the power semiconductors 41, a plurality of cooling ribs 29 are integrally moulded on an outer surface 21b of the housing wall 21, which is averted from the inner surface 21a. Additionally, a plurality of cooling ribs 29 are also moulded on an outer surface 22b of the housing base 22 which is averted from the power circuit board 40. The cooling ribs 29 enlarge the outer surface 21b and 22b of the housing wall 21 and the housing base 22, such that heat conduction between the housing wall 21, and between the housing base 22 and the environment is improved.

Fig. 3 shows a view of the control board 50, from a side which faces the housing base 22, and Fig. 4 shows a view of the control board 50 from a side which faces the power circuit board 40. The control board 50 incorporates the electric power connector 52, by means of which the control board 50 and, correspondingly, the power inverter 10 are connectable to an external direct current source and/or to an external control circuit, in a signal-transmitting arrangement. The electric power connector 52 is connected, in a current-conducting manner, with the positive pole contact terminal 53 and with the negative pole contact terminal 54, by means of which direct current from an external direct current source, via current-conducting studs 55 which are not represented here, can be fed to the control board 50.

Fig. 5 shows a view of the power circuit board 40 with the power semiconductors 41 and the capacitors 42, from a side which faces the clamping plate 61. The power semiconductors 41, in the edge region 43 of the power circuit board 40, are oriented perpendicularly to the latter and in parallel with the central longitudinal axis 30, and are mutually interconnected in the power circuit 44. The respective phase terminals 45 are thus electrically bonded with a half-bridge circuit, in which power semiconductors 41 are electrically interconnected. In this exemplary embodiment, four power semiconductors 41 respectively constitute a respective half-bridge circuit. Via the phase terminals 45, an alternating current can be tapped off from the power inverter 10. Moreover, on the power circuit board 40, the capacitors 42 are oriented perpendicularly to the power circuit board 40 and are soldered to the latter.

Fig. 6 shows an exploded view of the carriers 62 and the resilient clamps 63 in the preloading arrangement 60. Fig. 7 shows a view of the clamping plate 61 in the preloading arrangement 60, from a side which is averted from the resilient clamps 63, and Fig. 8 shows a view of the clamping plate 61 in the preloading arrangement 60, from a side which faces the resilient clamps 63. In this exemplary embodiment, the preloading arrangement 60 incorporates three elongated carriers 62, on each of which two resilient clamps 63 are arranged for two power semiconductors 41 respectively. The resilient clamps 63, by means of the bearing sections 65, are rotatably mounted on the respective carrier 62. The respective bearing sections 65 connect the two prongs 64a and 64b of the respective resilient clamps 63 to one another. If the preloading arrangement 60 is arranged on the power semiconductors 41, as represented in Fig. 1, the respective resilient clamps 63 are pre-loaded between the clamping edge 66 and the respective power semiconductors 41, and compress the respective power semiconductors 41 against the inner surface 21a of the housing wall 21. As a result, the power semiconductors 41 are coupled to the housing wall 21 in a large-surface and thermally conductive arrangement, and heat generated in the power semiconductors 41 can be evacuated to the exterior. By means of the stop lugs 67, the two resilient clamps 63 are secured to the respective carrier 62 in a non-displaceable manner, and are axially secured to the carrier 62 by means of the fixing edge 68. The clamping plate 61 further incorporates the through openings 69, into which the capacitors 42 on the power circuit board 40 project, as represented in Fig. 2.

Fig. 9 shows a view of the capacitor retaining plate 70, from a side which is averted from the clamping plate 61. The capacitor retaining plate 70 is fitted to the clamping plate 61, as shown in Fig. 2, and incorporates a plurality of location openings 72. The capacitor retaining plate 70 positions the capacitors 42 radially to the central longitudinal axis 30 in the location openings 72, and prevents any interruption of the customarily rigid and brittle soldered contacts between the capacitors 42 and the power circuit board 40 associated with vibrations or oscillations.

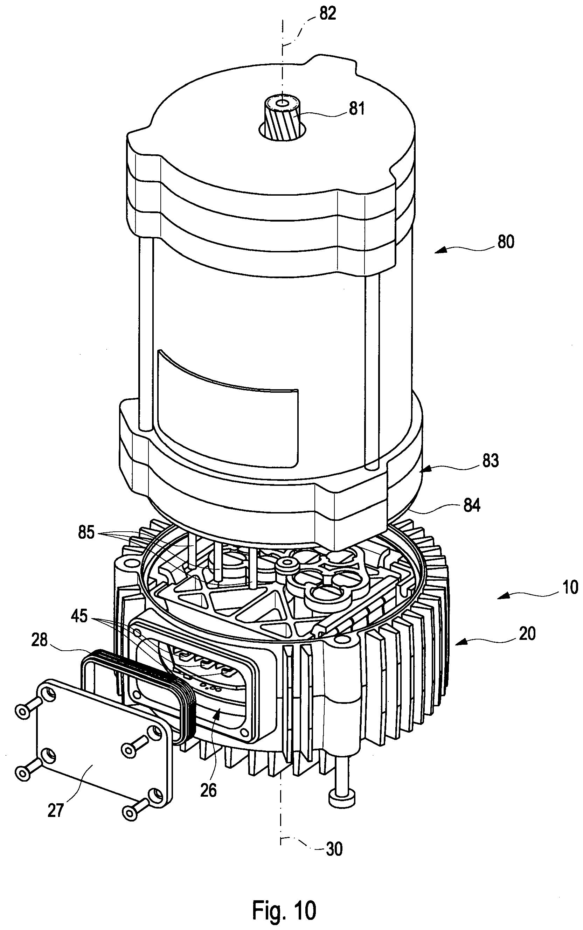

Fig. 10 shows an exploded view of the power inverter 10 and an electrical machine 80 fitted to the power inverter 10. The electrical machine 80 can, for example, be a permanently excited or separately excited synchronous machine, an asynchronous machine or another type of electrical machine. The electrical machine 80 incorporates a drive shaft 81 having a drive shaft axis 82, and is fitted to an opposing end 83 of the drive shaft 81 to the power inverter 10. The electrical machine 80 and the power inverter 10 are thus arranged coaxially to each other. A machine wall 84 of the electrical machine 80 thus closes the housing 20, in opposition to the housing base 22 and perpendicularly to the central longitudinal axis 30. Between the machine wall 84 and the carriers 62, the clamping plate 61, together with the capacitor retaining plate 70, is clamped axially to the central longitudinal axis 30. Appropriately, phase terminal studs 85 of the electrical machine 80 are brought out axially through the clamping plate 61 and the capacitor retaining plate 70 to the phase terminals 45 of the power circuit board 40. Via the housing opening 26 in the housing wall 21, the phase terminal studs 85 and the phase terminals 45 are accessible from the exterior, and can be electrically bonded to one another. The housing opening 26 is closed by the cover 27 with its annular seal 28.

In summary, the power semiconductors 41 in the power inverter 10 according to the invention are directly coupled to the inner surface 21a of the housing wall 21 in a thermally conductive, large-surface arrangement. No layers or only a heat-conducting and perhaps insulating layer are arranged between the inner surface 21a of the housing wall 21 and the power semiconductors 41. As a result, heat conduction between the power semiconductors 41 and the housing wall 21, and the cooling of the power semiconductors 41, are significantly improved.

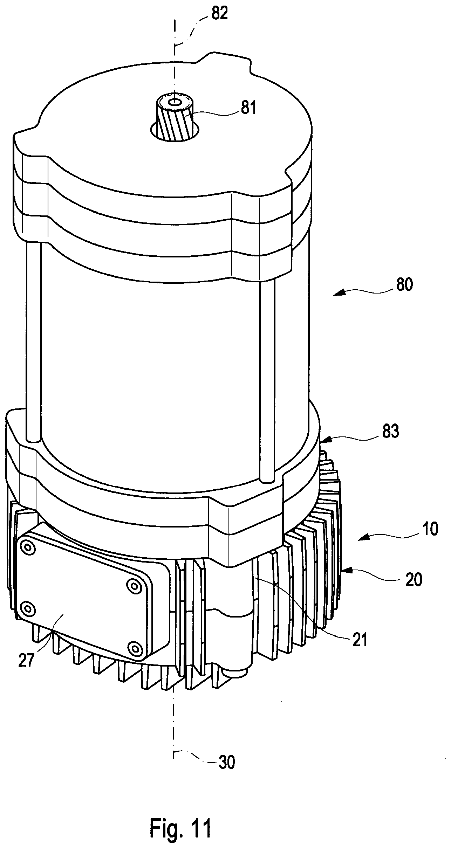

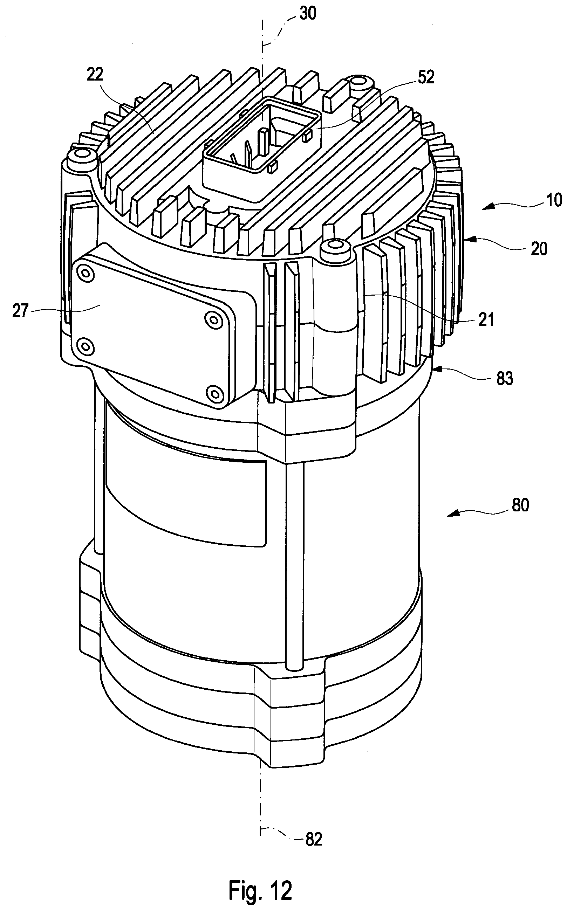

Fig. 11 and Fig. 12 show views of the electrical machine 80 according to the invention, with the power inverter 10. The electrical machine 80 can, for example, be a permanently excited or separately excited synchronous machine, an asynchronous machine or another type of electrical machine. The power inverter 10 and the electrical machine 80 are arranged coaxially to each other, wherein the power inverter 10 is fitted to the end 83 of the electrical machine 80 opposite from the drive shaft 81. Via the electric power connector 52, as shown in Fig. 12, the power inverter 10 can be supplied with direct current, and the latter is converted into an alternating current. The alternating current can be supplied to the electrical machine 80, thus driving the drive shaft 81.

## Claims

1. Power inverter (10) for an electrical machine (80),
- wherein the power inverter (10) comprises a power circuit board (40) with a plurality of power semiconductors (41),
- wherein the power inverter (10) comprises a housing (20) with a housing wall (21), which extends around a central longitudinal axis (30) of the housing (20),
- wherein the power circuit board (40) is fitted in the housing (20) perpendicularly to the central longitudinal axis (30),
- wherein the power inverter (10) comprises a preloading arrangement (60) with at least one resilient clamp (63) and a clamping plate (61) in parallel with the power circuit board (40),
- wherein the power semiconductors (41) are arranged in an edge region (43) of the power circuit board (40), and are oriented perpendicularly to the latter and in parallel with the central longitudinal axis (30), and
- wherein the at least one resilient clamp (63) is pre-loaded between at least one of the power semiconductors (41) and the clamping plate (61), and compresses at least one of the power semiconductors (41) against an inner surface (21a) of the housing wall (21),
**characterized in**
- **that** at least one carrier (62) of the preloading arrangement (60) is fitted to the housing wall (21) and oriented perpendicularly to the central longitudinal axis (30) and in parallel with at least one of the power semiconductors (41),
- **that** the at least one resilient clamp (63) incorporates two flat prongs (64a, 64b), which are connected to each other by means of a bearing section (65) which is arranged on the respective carrier (62),
- **that** the clamping plate (61) incorporates a clamping edge (66) which is oriented in parallel with the respective carrier (62), and
- **that** one prong (64a) of the at least one resilient clamp (63) engages with at least one of the power semiconductors (41), and the other prong (64b) of the at least one resilient clamp (63) engages with the clamping edge (66) of the clamping plate (61), in a pre-loaded arrangement.

2. Power inverter according to Claim 1,
**characterized in that**
between the inner surface (21a) of the housing wall (21) and at least one of the power semiconductors (41), a heat-conducting layer (24), preferably a heat-conducting film or a heat-conducting paste or a casting compound, is secured in contact with the latter.

3. Power inverter according to Claim 1 or 2,
**characterized in that**
- the clamping plate (61) incorporates at least one stop lug (67), which engages with the bearing section (65) of the at least one resilient clamp (63), parallel to the respective carrier (62) and/or secures the at least one carrier (62) axially to the power semiconductors (41), and/or
- the clamping plate (61) incorporates a fixing edge (68), which secures the bearing section (65) of the at least one resilient clamp (63) to the respective carrier (62), axially to the power circuit board (40).

4. Power inverter according to one of the preceding claims,
**characterized in that**
on the inner surface (21a) of the housing wall (21), at least one planar clamping section (23) is configured for at least one of the power semiconductors (41).

5. Power inverter according to Claim 4,
**characterized in that**
- a plurality of planar clamping sections (23), preferably three planar clamping sections (23), are configured in the circumferential direction, distributed over the inner surface (21a) of the housing wall (21), and
- a half-bridge circuit is assigned to each clamping section (23), in which two of the power semiconductors (41), or a whole-number multiple thereof, are electrically interconnected.

6. Power inverter according to Claim 4 or 5,
**characterized in that**
- for each of the clamping sections (23), a respective carrier (62) and, for each of the power semiconductors (41) in the respective clamping section (23), a respective resilient clamp (63) are provided on the carrier (62), and
- in the respective clamping section (23), the individual power semiconductors (41) are compressed against the inner surface (21a) of the housing wall (21) by the individual resilient clamps (63).

7. Power inverter according to one of the preceding claims,
**characterized in that**
- a plurality of capacitors (42) are orientated perpendicularly to the power circuit board (40), and towards the clamping plate (61), on the power circuit board (40), and
- the clamping plate (61) incorporates at least one through opening (69), into which the capacitors (42) project axially.

8. Power inverter according to Claim 7,
**characterized in that**
- on the clamping plate (61), a capacitor retaining plate (70), which is averted from the power circuit board (40), is fitted or is integrally configured, and
- the capacitor retaining plate (70) positions the capacitors (42) which project axially through the respective through opening (69) in the clamping plate (61), radially to the central longitudinal axis (30), preferably in location openings (72).

9. Power inverter according to one of the preceding claims,
**characterized in that**
- a control board (50) is fitted between the power circuit board (40) and a housing base (22), which is averted from the clamping plate (61), perpendicularly to the central longitudinal axis (30), and
- the control board (50) is electrically insulated from the housing base (22) and the power circuit board (40), and is preferably arranged with a clearance to the latter.

10. Power inverter according to Claim 9,
**characterized in that**
- the control board (50) incorporates an electric power connector (52), which is averted from the power circuit board (50) and is brought out to the exterior through a terminal opening (25) in the housing base (22), and/or
- the control board (50) incorporates a positive pole contact terminal (53) and a negative pole contact terminal (54) which, by means of a respective conductor, electrically bond the control board (50) to the power circuit board (40), preferably in the form of current-conducting studs (55) which are routed through the power circuit board (40), axially to the central longitudinal axis (30).

11. Power inverter according to one of the preceding claims,
**characterized in that**
- the power semiconductors (41) on the power circuit board (40) constitute a power circuit (44) having three phase terminals (45), and
- the phase terminals (45) are arranged on the power circuit board (40) perpendicularly to the central longitudinal axis (30), facing a housing opening (26) in the housing wall (21), and are accessible from the exterior.

12. Power inverter according to one of the preceding claims,
**characterized in that**
- a plurality of cooling ribs (29) are integrally moulded on an outer surface (21b) of the housing wall (21), which is averted from the inner surface (21a), and/or on an outer side (22b) of a housing base (22), which is averted from the power circuit board (40), and/or
- a cooling device is coupled to the outer surface (21b) of the housing wall (21) which is averted from the inner surface (21a) and/or to the outer side (22b) of a housing base (32) which is averted from the power circuit board (40), in a thermally conductive manner, and the housing wall (21) and/or the housing base (22) can be cooled by means of a cooling medium which is carried in the cooling device.

13. Power inverter according to one of the preceding claims,
**characterized in that**
- an electrical machine (80) is fitted to the power inverter (10), wherein a drive shaft axis (82) of the drive shaft (81) of the electrical machine (80) is oriented in parallel with the central longitudinal axis (30), and
- a machine wall (84) closes the housing (20) perpendicularly to the central longitudinal axis (30), and clamps the clamping plate (61) in the housing (20), axially to the central longitudinal axis (30), in a pre-loaded arrangement.

14. Electrical machine (80) having a drive shaft (81) which is rotatable about a drive shaft axis (82) and having a power inverter (10),
**characterized in that** the power inverter (10) is designed according to one of Claims 1 to 13.

## Patentansprüche

1. Wechselrichter (10) für eine elektrische Maschine (80),
- wobei der Wechselrichter (10) eine Leistungsplatine (40) mit einer Vielzahl von Leistungshalbleitern (41) umfasst,
- wobei der Wechselrichter (10) ein Gehäuse (20) mit einer Gehäusewand (21) umfasst, die sich um eine Mittellängsachse (30) des Gehäuses (20) erstreckt,
- wobei die Leistungsplatine (40) senkrecht zur Mittellängsachse (30) in das Gehäuse (20) eingebaut ist,
- wobei der Wechselrichter (10) eine Vorspannanordnung (60) mit mindestens einer federnden Klemme (63) und einer parallel zur Leistungsplatine (40) ausgerichteten Klemmplatte (61) umfasst,
- wobei die Leistungshalbleiter (41) in einem Randbereich (43) der Leistungsplatine (40) angeordnet sind und senkrecht zu dieser und parallel zur Mittellängsachse (30) ausgerichtet sind, und
- wobei die mindestens eine federnde Klemme (63) zwischen mindestens einem der Leistungshalbleiter (41) und der Klemmplatte (61) vorgespannt ist und mindestens einen der Leistungshalbleiter (41) gegen eine Innenfläche (21a) der Gehäusewand (21) drückt,
**dadurch gekennzeichnet,**
- **dass** mindestens ein Träger (62) der Vorspannanordnung (60) an der Gehäusewand (21) angebracht und senkrecht zur Mittellängsachse (30) und parallel zu mindestens einem der Leistungshalbleiter (41) ausgerichtet ist,
- **dass** die mindestens eine federnde Klemme (63) zwei flache Zinken (64a, 64b) aufweist, die über einen am jeweiligen Träger (62) angeordneten tragenden Abschnitt (65) miteinander verbunden sind,
- **dass** die Klemmplatte (61) eine Klemmkante (66) aufweist, die parallel zu dem jeweiligen Träger (62) ausgerichtet ist, und
- **dass** eine Zinke (64a) der mindestens einen federnden Klemme (63) mit mindestens einem der Leistungshalbleiter (41) in Eingriff steht und die andere Zinke (64b) der mindestens einen federnden Klemme (63) mit der Klemmkante (66) der Klemmplatte (61) in einer vorgespannten Anordnung in Eingriff steht.

2. Wechselrichter nach Anspruch 1,
**dadurch gekennzeichnet, dass**
zwischen der Innenfläche (21a) der Gehäusewand (21) und mindestens einem der Leistungshalbleiter (41) eine wärmeleitende Schicht (24), vorzugsweise eine wärmeleitende Folie oder eine wärmeleitende Paste oder eine Vergussmasse, in Kontakt mit letzterer befestigt ist.

3. Wechselrichter nach Anspruch 1 oder 2,
**dadurch gekennzeichnet, dass**
- die Klemmplatte (61) mindestens eine Anschlagnase (67) aufweist, die mit dem tragenden Abschnitt (65) der mindestens einen federnden Klemme (63) parallel zu dem jeweiligen Träger (62) in Eingriff steht und/oder den mindestens einen Träger (62) axial an den Leistungshalbleitern (41) sichert, und/oder
- die Klemmplatte (61) eine Befestigungskante (68) aufweist, die den tragenden Abschnitt (65) der mindestens einen federnden Klemme (63) an dem jeweiligen Träger (62) axial zur Leistungsplatine (40) sichert.

4. Wechselrichter nach einem der vorstehenden Ansprüche,
**dadurch gekennzeichnet, dass**
an der Innenfläche (21a) der Gehäusewand (21) mindestens ein flächiger Klemmabschnitt (23) für mindestens einen der Leistungshalbleiter (41) ausgebildet ist.

5. Wechselrichter nach Anspruch 4,
**dadurch gekennzeichnet, dass**
- eine Vielzahl von flächigen Klemmabschnitten (23), vorzugsweise drei flächige Klemmabschnitte (23), in Umfangsrichtung über die Innenfläche (21a) der Gehäusewand (21) verteilt ausgebildet sind, und
- jedem Klemmabschnitt (23) eine Halbbrückenschaltung zugeordnet ist, in der zwei der Leistungshalbleiter (41) oder ein ganzzahliges Vielfaches davon elektrisch miteinander verbunden sind.

6. Wechselrichter nach Anspruch 4 oder 5,
**dadurch gekennzeichnet, dass**
- für jeden der Klemmabschnitte (23) ein jeweiliger Träger (62) und für jeden der Leistungshalbleiter (41) in dem jeweiligen Klemmabschnitt (23) eine jeweilige federnde Klemme (63) an dem Träger (62) vorgesehen sind, und
- im jeweiligen Klemmabschnitt (23) die einzelnen Leistungshalbleiter (41) durch die einzelnen federnden Klemmen (63) gegen die Innenfläche (21a) der Gehäusewand (21) gedrückt werden.

7. Wechselrichter nach einem der vorstehenden Ansprüche,
**dadurch gekennzeichnet, dass**
- eine Vielzahl von Kondensatoren (42) senkrecht zur Leistungsplatine (40) und in Richtung zur Klemmplatte (61) hin auf der Leistungsplatine (40) ausgerichtet sind, und
- die Klemmplatte (61) mindestens eine Durchgangsöffnung (69) aufweist, in die die Kondensatoren (42) axial hineinragen.

8. Wechselrichter nach Anspruch 7,
**dadurch gekennzeichnet, dass**
- auf der Klemmplatte (61) eine von der Leistungsplatine (40) abgewandte Kondensatorhalteplatte (70) angebracht oder einstückig ausgebildet ist, und
- die Kondensatorhalteplatte (70) die axial durch die jeweilige Durchgangsöffnung (69) in der Klemmplatte (61) ragenden Kondensatoren (42) radial zur Mittellängsachse (30), vorzugsweise in Aufnahmeöffnungen (72) positioniert.

9. Wechselrichter nach einem der vorstehenden Ansprüche,
**dadurch gekennzeichnet, dass**
- zwischen der Leistungsplatine (40) und einem von der Klemmplatte (61) abgewandten Gehäuseboden (22) senkrecht zur Mittellängsachse (30) eine Steuerplatine (50) eingebaut ist, und
- die Steuerplatine (50) von dem Gehäuseboden (22) und der Leistungsplatine (40) elektrisch isoliert und vorzugsweise mit einem Abstand zu letzterer angeordnet ist.

10. Wechselrichter nach Anspruch 9,
**dadurch gekennzeichnet, dass**
- die Steuerplatine (50) einen von der Leistungsplatine (50) abgewandten Stromanschluss (52) aufweist, der durch eine Anschlussöffnung (25) im Gehäuseboden (22) nach außen geführt ist, und/oder
- die Steuerplatine (50) eine Pluspol-Kontaktklemme (53) und eine Minuspol-Kontaktklemme (54) aufweist, die die Steuerplatine (50) über einen jeweiligen Leiter mit der Leistungsplatine (40) elektrisch verbinden, vorzugsweise in Form von stromführenden Bolzen (55), die axial zur Mittellängsachse (30) durch die Leistungsplatine (40) geführt sind.

11. Wechselrichter nach einem der vorstehenden Ansprüche,
**dadurch gekennzeichnet, dass**
- die Leistungshalbleiter (41) auf der Leistungsplatine (40) eine Leistungsschaltung (44) mit dreiphasigen Anschlüssen (45) bilden, und
- die Phasenanschlüsse (45) auf der Leistungsplatine (40) senkrecht zur Mittellängsachse (30), einer Gehäuseöffnung (26) in der Gehäusewand (21) zugewandt, angeordnet und von außen zugänglich sind.

12. Wechselrichter nach einem der vorstehenden Ansprüche,
**dadurch gekennzeichnet, dass**
- eine Vielzahl von Kühlrippen (29) an einer der Innenfläche (21a) abgewandten Außenfläche (21b) der Gehäusewand (21) und/oder an einer der Leistungsplatine (40) abgewandten Außenseite (22b) eines Gehäusebodens (22) angeformt sind, und/oder
- eine Kühlvorrichtung mit der von der Innenfläche (21a) abgewandten Außenfläche (21b) der Gehäusewand (21) und/oder mit der von der Leistungsplatine (40) abgewandten Außenseite (22b) eines Gehäusebodens (32) wärmeleitend gekoppelt ist und die Gehäusewand (21) und/oder der Gehäuseboden (22) mittels eines in der Kühlvorrichtung geführten Kühlmediums kühlbar ist.

13. Wechselrichter nach einem der vorstehenden Ansprüche,
**dadurch gekennzeichnet, dass**
- an dem Wechselrichter (10) eine elektrische Maschine (80) angebracht ist, wobei eine Antriebswellenachse (82) der Antriebswelle (81) der elektrischen Maschine (80) parallel zu der Mittellängsachse (30) ausgerichtet ist, und
- eine Maschinenwand (84) das Gehäuse (20) senkrecht zur Mittellängsachse (30) abschließt und die Klemmplatte (61) im Gehäuse (20) axial zur Mittellängsachse (30) in einer vorgespannten Anordnung einspannt.

14. Elektrische Maschine (80) mit einer Antriebswelle (81), die um eine Antriebswellenachse (82) drehbar ist, und mit einem Wechselrichter (10),
**dadurch gekennzeichnet, dass** der Wechselrichter (10) nach einem der Ansprüche 1 bis 13 ausgestaltet ist.

## Revendications

1. Onduleur de puissance (10) pour une machine électrique (80),
- dans lequel l'onduleur de puissance (10) comprend une carte de circuit de puissance (40) avec une pluralité de semi-conducteurs de puissance (41),
- dans lequel l'onduleur de puissance (10) comprend un boîtier (20) avec une paroi de boîtier (21), qui s'étend autour d'un axe longitudinal central (30) du boîtier (20),
- dans lequel la carte de circuit de puissance (40) est montée dans le boîtier (20) perpendiculairement à l'axe longitudinal central (30),
- dans lequel l'onduleur de puissance (10) comprend un agencement de précharge (60) avec au moins une bride de serrage élastique (63) et une plaque de serrage (61) en parallèle avec la carte de circuit de puissance (40),
- dans lequel les semi-conducteurs de puissance (41) sont agencés dans une région de bord (43) de la carte de circuit de puissance (40), et sont orientés perpendiculairement à cette dernière et en parallèle avec l'axe longitudinal central (30), et
- dans lequel la au moins une bride de serrage élastique (63) est préchargée entre au moins un des semi-conducteurs de puissance (41) et la plaque de serrage (61), et comprime au moins un des semi-conducteurs de puissance (41) contre une surface intérieure (21a) de la paroi de boîtier (21),
**caractérisé en ce que**
- le au moins un support (62) de l'agencement de précharge (60), est monté sur la paroi de boîtier (21) et orienté perpendiculairement à l'axe longitudinal central (30) et en parallèle avec au moins un des semi-conducteurs de puissance (41),
- **en ce que** la au moins une bride de serrage élastique (63) intègre deux pattes plates (64a, 64b), qui sont reliées l'une à l'autre au moyen d'une section d'appui (65) qui est agencée sur le support (62) respectif,
- **en ce que** la plaque de serrage (61) intègre un bord de serrage (66) qui est orienté en parallèle avec le support (62) respectif, et
- **en ce qu'**une patte (64) de la au moins une bride de serrage élastique (63) se met en prise avec au moins un des semi-conducteurs de puissance (41), et l'autre patte (64b) de la au moins une bride de serrage élastique (63) se met en prise avec le bord de serrage (66) de la plaque de serrage (61), dans un agencement préchargé.

2. Onduleur de puissance selon la revendication 1,
**caractérisé en ce que**
entre la surface intérieure (21a) de la paroi de boîtier (21) et au moins un des semi-conducteurs de puissance (41), une couche thermoconductrice (24), de préférence un film thermoconducteur ou une pâte thermoconductrice ou un composé de moulage, est fixé(e) en contact avec ce dernier.

3. Onduleur de puissance selon la revendication 1 ou 2,
**caractérisé en ce que**
- la plaque de serrage (61) intègre au moins un ergot d'arrêt (67), qui se met en prise avec la section d'appui (65) de la au moins une bride de serrage élastique (63), en parallèle au support (62) respectif et/ou fixe le au moins un support (62) axialement aux semi-conducteurs de puissance (41), et/ou
- la plaque de serrage (61) intègre un bord de fixation (68), qui fixe la section d'appui (65) de la au moins une bride de serrage élastique (63) au support (62) respectif, axialement à la carte de circuit de puissance (40).

4. Onduleur de puissance selon l'une des revendications précédentes,
**caractérisé en ce que**
sur la surface intérieure (21a) de la paroi de boîtier (21), au moins une section de serrage plane (23) est configurée pour au moins un des semi-conducteurs de puissance (41).

5. Onduleur de puissance selon la revendication 4,
**caractérisé en ce que**
- une pluralité de sections de serrage planes (23), de préférence trois sections de serrage planes (23), sont configurées dans la direction circonférentielle, distribuées sur la surface intérieure (21a) de la paroi de boîtier (21), et
- un circuit en demi-pont est affecté à chaque section de serrage (23), dans lequel deux des semi-conducteurs de puissance (41), ou un nombre entier multiple de celui-ci, sont interconnectés électriquement.

6. Onduleur de puissance selon la revendication 4 ou 5,
**caractérisé en ce que**
- pour chacune des sections de serrage (23), un support (62) respectif et, pour chacun des semi-conducteurs de puissance (41) dans la section de serrage (23) respective, une bride de serrage élastique (63) respective sont prévus sur le support (62), et
- dans la section de serrage (23) respective, les semi-conducteurs de puissance (41) individuels sont comprimés contre la surface intérieure (21a) de la paroi de boîtier (21) par les brides de serrage élastiques (63) individuelles.

7. Onduleur de puissance selon l'une des revendications précédentes,
**caractérisé en ce que**
- une pluralité de condensateurs (42) sont orientés perpendiculairement à la carte de circuit de puissance (40), et vers la plaque de serrage (61), sur la carte de circuit de puissance (40), et
- la plaque de serrage (61) intègre au moins une ouverture de passage (69), dans laquelle les condensateurs (42) se projettent axialement.

8. Onduleur de puissance selon la revendication 7,
**caractérisé en ce que**
- sur la plaque de serrage (61), est montée ou est configurée d'un seul tenant une plaque de retenue de condensateurs (70), qui est à l'opposé de la carte de circuit de puissance (40), et
- la plaque de retenue de condensateurs (70) positionne les condensateurs (42) qui font saillie axialement à travers l'ouverture de passage (69) respective dans la plaque de serrage (61), radialement par rapport à l'axe longitudinal central (30), de préférence dans des ouvertures de positionnement (72).

9. Onduleur de puissance selon l'une des revendications précédentes,
**caractérisé en ce que**
- une carte de commande (50) est montée entre la carte de circuit de puissance (40) et une base de boîtier (22), laquelle est à l'opposé de la plaque de serrage (61), perpendiculairement à l'axe longitudinal central (30), et
- la carte de commande (50) est isolée électriquement de la base de boîtier (22) et de la carte de circuit de puissance (40), et est de préférence agencée avec un jeu par rapport à cette dernière.

10. Onduleur de puissance selon la revendication 9,
**caractérisé en ce que**
- la carte de commande (50) intègre un connecteur de puissance électrique (52), qui est à l'opposé de la carte de circuit de puissance (50) et est amené vers l'extérieur à travers une ouverture de borne (25) dans la base de boîtier (22), et/ou
- la carte de commande (50) intègre une borne de contact de pôle positif (53) et une borne de contact de pôle négatif (54) qui, au moyen d'un conducteur respectif, assurent la liaison électrique de la carte de commande (50) à la carte de circuit de puissance (40), de préférence sous la forme de plots conducteurs de courant (55) qui sont acheminés à travers la carte de circuit de puissance (40), axialement à l'axe longitudinal central (30).

11. Onduleur de puissance selon l'une des revendications précédentes,
**caractérisé en ce que**
- les semi-conducteurs de puissance (41) sur la carte de circuit de puissance (40) constituent un circuit de puissance (44) présentant des bornes triphasées (45), et
- les bornes de phase (45) sont agencées sur la carte de circuit de puissance (40) perpendiculairement à l'axe longitudinal central (30), en face d'une ouverture de boîtier (26) dans la paroi de boîtier (21), et sont accessibles depuis l'extérieur.

12. Onduleur de puissance selon l'une des revendications précédentes,
**caractérisé en ce que**
- une pluralité de nervures de refroidissement (29) sont moulées d'un seul tenant sur une surface extérieure (21b) de la paroi de boîtier (21), qui est à l'opposé de la surface intérieure (21a) et/ou sur un côté extérieur (22b) d'une base de boîtier (22), qui est à l'opposé de la carte de circuit de puissance (40), et/ou
- un dispositif de refroidissement est accouplé à la surface extérieure (21b) de la paroi de boîtier (21) qui est à l'opposé de la surface intérieure (21a) et/ou au côté extérieur (22b) d'une base de boîtier (32) qui est à l'opposé de la carte de circuit de puissance (40), d'une manière thermoconductrice, et la paroi de boîtier (21) et/ou la base de boîtier (22) peuvent être refroidies au moyen d'un milieu de refroidissement qui est transporté par le dispositif de refroidissement.

13. Onduleur de puissance selon l'une des revendications précédentes,
**caractérisé en ce que**
- une machine électrique (80) est montée sur l'onduleur de puissance (10), dans lequel un axe d'arbre d'entraînement (82) de l'arbre d'entraînement (81) de la machine électrique (80) est orienté en parallèle à l'axe longitudinal central (30), et
- une paroi de machine (84) ferme le boîtier (20) perpendiculairement à l'axe longitudinal central (30), et serre la plaque de serrage (61) dans le boîtier (20), axialement par rapport à l'axe longitudinal central (30), dans un agencement préchargé.

14. Machine électrique (80) présentant un arbre d'entraînement (81) qui est rotatif autour d'un axe d'arbre d'entraînement (82) et présentant un onduleur de puissance (10),
**caractérisé en ce que** l'onduleur de puissance (10) est conçu selon l'une des revendications 1 à 13.
